(19) Europäisches Patentamt
European Patent Office
Office européen des brevets

(11) EP 4 365 238 A1

(12) **EUROPEAN PATENT APPLICATION**
published in accordance with Art. 153(4) EPC

(43) Date of publication:
**08.05.2024 Bulletin 2024/19**

(21) Application number: **22832993.4**

(22) Date of filing: **23.06.2022**

(51) International Patent Classification (IPC):
***C08L 83/04*** *(2006.01)* ***C08K 3/08*** *(2006.01)*

(52) Cooperative Patent Classification (CPC):
**C08K 3/08; C08L 83/04**

(86) International application number:
**PCT/JP2022/025063**

(87) International publication number:
**WO 2023/276846 (05.01.2023 Gazette 2023/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.07.2021 JP 2021110436**

(71) Applicant: **SHIN-ETSU CHEMICAL CO., LTD.**
**Tokyo 1000005 (JP)**

(72) Inventor: **AKIBA Shota**
**Annaka-shi, Gunma 379-0224 (JP)**

(74) Representative: **Angerhausen, Christoph**
**Boehmert & Boehmert**
**Anwaltspartnerschaft mbB**
**Pettenkoferstrasse 22**
**80336 München (DE)**

(54) **HEAT-CONDUCTIVE SILICONE COMPOSITION, SEMICONDUCTOR DEVICE, AND METHOD FOR MANUFACTURING SAME**

(57) Provided is a thermal conductive silicone composition capable of achieving a favorable heat dissipation effect. The thermal conductive silicone composition contains:
(A) an organopolysiloxane that has a kinetic viscosity of 10 to 100,000 $mm^2/s$ at 25°C, and contains at least two silicon atom-bonded alkenyl groups per molecule;
(B) an organohydrogenpolysiloxane that contains at least two silicon atom-bonded hydrogen atoms (SiH groups) per molecule;
(C) a catalyst for hydrosilylation reaction;
(D) a silver powder having a tap density of not lower than 3.0 $g/cm^3$, a specific surface area of not larger than 2.0 $m^2/g$, and an aspect ratio of 2.0 to 50; and
(E) a spherical silver powder having an average particle size of 0.5 to 100 μm, a tap density of not lower than 4.0 $g/cm^3$, a specific surface area of not larger than 1.5 $m^2/g$, and an aspect ratio of smaller than 2.0.

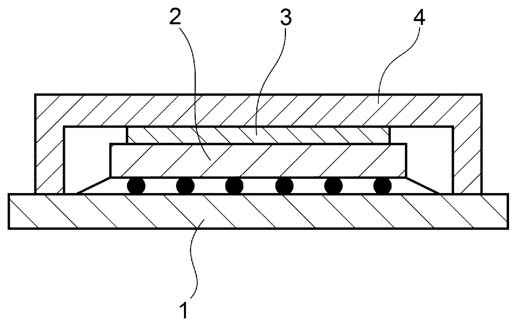

FIG.1

EP 4 365 238 A1

## Description

### TECHNICAL FIELD

The present invention relates to a silicone composition superior in thermal conductivity, a semiconductor device, and a method for producing such semiconductor device.

### BACKGROUND ART

Since most electronic parts generate heat during use, such heat has to be eliminated from an electronic part(s) to allow the electronic part to function properly. Especially, since integrated circuit elements such as a CPU used in a personal computer have exhibited a substantial increase in amount of heat generation due to higher operation frequencies, countermeasures against heat are now critical. In order to solve this problem, there have been proposed various methods for removing heat. Particularly, with regard to electronic parts generating large amounts of heat, there has been proposed a method for dissipating the heat by interposing a thermal conductive material such as a thermal conductive grease or a thermal conductive sheet between an electronic part and a member such as a heatsink.

JP-A-Hei 2-153995 (Patent document 1) discloses a silicone grease composition prepared by adding to a particular organopolysiloxane a spherical hexagonal aluminum nitride powder having a particle size within a given range. JP-A-Hei 3-14873 (Patent document 2) discloses a thermal conductive silicone grease prepared by combining an aluminum nitride powder with a finer particle size and an aluminum nitride powder with a larger particle size. JP-A-Hei 10-110179 (Patent document 3) discloses a thermal conductive silicone grease prepared by combining an aluminum nitride powder and a zinc oxide powder. JP-A2000-63872 (Patent document 4) discloses a thermal conductive grease composition employing an aluminum nitride powder surface-treated with organosilane.

The thermal conductivity of aluminum nitride is 70 to 270 W/mK. Diamond is known as a material having a thermal conductivity higher than that of aluminum nitride, and has a thermal conductivity of 900 to 2,000 W/mK. JP-A 2002-30217 (Patent document 5) discloses a thermal conductive silicone composition prepared by adding diamond, zinc oxide and a dispersant to a silicone resin.

Further, JP-A 2000-63873 (Patent document 6) and JP-A 2008-222776 (Patent document 7) disclose a thermal conductive grease composition prepared by mixing a base oil such as a silicone oil with a metallic aluminum powder.

Furthermore, there are also known, for example, Japanese Patent No.3130193 (Patent document 8) and Japanese Patent No.3677671 (Patent document 9) in which silver powders with high thermal conductivities are used fillers.

### PRIOR ART DOCUMENTS

#### Patent documents

Patent document 1: JP-A-Hei 2-153995
Patent document 2: JP-A-Hei 3-14873
Patent document 3: JP-A-Hei 10-110179
Patent document 4: JP-A 2000-63872
Patent document 5: JP-A 2002-30217
Patent document 6: JP-A 2000-63873
Patent document 7: JP-A 2008-222776
Patent document 8: Japanese Patent No.3130193
Patent document 9: Japanese Patent No.3677671


### SUMMARY OF THE INVENTION

#### Problems to be solved by the invention

When applying a thermal conductive material or a thermal conductive grease to sites requiring thicknesses larger than a minimum thickness of such thermal conductive material or thermal conductive grease when compressed (BLT), there is a problem of causing a deteriorated thermal resistance. In this regard, demanded is a thermal conductive material having a satisfactory heat dissipation effect with respect to the amount of heat generated by integrated circuit elements such as CPUs of recent days.

Thus, it is an object of the present invention to provide a thermal conductive silicone composition capable of

achieving a favorable heat dissipation effect.

Means to solve the problems

The inventor of the present invention diligently conducted a series of studies to achieve the above object, and completed the invention as follows. That is, the inventor found that a significantly excellent thermal conductivity could be achieved with a cured product of a composition prepared by mixing a silver powder having a specific tap density, specific surface area, and aspect ratio and a spherical silver powder having a specific particle size into a specific organopolysiloxane.

Specifically, the present invention is to provide the following thermal conductive silicone composition and others.

<1> A thermal conductive silicone composition comprising:

(A) 100 parts by mass of an organopolysiloxane that has a kinetic viscosity of 10 to 100,000 $mm^2/s$ at 25°C, and contains at least two silicon atom-bonded alkenyl groups per molecule;
(B) an organohydrogenpolysiloxane that contains at least two silicon atom-bonded hydrogen atoms (SiH groups) per molecule, and is in an amount at which the number of the silicon atom-bonded hydrogen atoms in the component (B) is 0.8 to 6 per 1 alkenyl group in the entire composition;
(C) an effective amount of a catalyst for hydrosilylation reaction;
(D) 500 to 3,000 parts by mass of a silver powder having a tap density of not lower than 3.0 $g/cm^3$, a specific surface area of not larger than 2.0 $m^2/g$, and an aspect ratio of 2.0 to 50; and
(E) 500 to 3,000 parts by mass of a spherical silver powder having an average particle size of 0.5 to 100 $\mu m$, a tap density of not lower than 4.0 $g/cm^3$, a specific surface area of not larger than 1.5 $m^2/g$, and an aspect ratio of smaller than 2.0.

<2> The thermal conductive silicone composition according to <1>, wherein a ratio $\alpha/\beta$ of a mass $\alpha$ of the component (D) to a mass $\beta$ of the component (E) is 0.1 to 6.
<3> A cured product of the thermal conductive silicone composition according to <1> or <2>.
<4> A semiconductor device comprising a heat-generating electronic part and a heat dissipator wherein the cured product of the thermal conductive silicone composition according to <3> is interposed between the heat-generating electronic part and the heat dissipator.
<5> A method for producing a semiconductor device, comprising a step in which the thermal conductive silicone composition according to <1> or <2> that is interposed between a heat-generating electronic part and a heat dissipator is heated to a temperature of 80°C or higher while being subjected to a pressure of 0.01 MPa or higher.

Effects of the invention

Since the cured product of the thermal conductive silicone composition of the present invention has an excellent thermal conductivity, it is suitable for use in a semiconductor device.

BRIEF DESCRIPTION OF THE DRAWINGS

[FIG.1] is a vertical cross-sectional schematic diagram showing one example of a semiconductor device of the present invention.

MODE FOR CARRYING OUT THE INVENTION

The thermal conductive silicone composition of the present invention is described in detail hereunder.

Component (A)

An organopolysiloxane as a component (A) is a base polymer of the composition of the present invention, and contains at least two silicon atom-bonded alkenyl groups per molecule.

The molecular structure of the component (A) may, for example, be a linear structure and a cyclic structure; while these structures may have branched moieties, preferred is a linear diorganopolysiloxane whose main chain is basically composed of repeating diorganosiloxane units, and whose molecular chain ends are both blocked by a triorganosiloxy group.

The kinetic viscosity of the component (A) at 25°C is 10 to 100,000 $mm^2/s$, preferably 100 to 50,000 $mm^2/s$.

When the kinetic viscosity is lower than 10 $mm^2/s$, oil bleeding is more likely to occur if the composition contains such component (A); when the kinetic viscosity is higher than 100,000 $mm^2/s$, a composition containing such component (A) will exhibit an impaired handling property due to the composition's increased absolute viscosity. Here, in this specification, the kinetic viscosity of the organopolysiloxane as the component (A) is a value measured by an Ostwald viscometer at 25°C.

Examples of the silicon atom-bonded alkenyl groups in the component (A) include groups preferably having 2 to 8, more preferably 2 to 4 carbon atoms, such as a vinyl group, an allyl group, a butenyl group, a pentenyl group, a hexenyl group, and a heptenyl group, of which a vinyl group is particularly preferred. When the organopolysiloxane as the component (A) has a linear structure, it will suffice so long as there are two or more silicon atom-bonded alkenyl groups per molecule. These alkenyl groups may be bonded only to silicon atoms at the molecular chain ends, or only to silicon atoms at moieties other than the molecular chain ends; or these alkenyl groups may be bonded to silicon atoms both at the molecular chain ends and moieties other than the molecular chain ends.

As organic groups other than alkenyl groups in the component (A) that are bonded to silicon atoms, there may be employed unsubstituted or halogen-substituted monovalent hydrocarbon groups, examples of which include alkyl groups, especially alkyl groups having 1 to 10 carbon atoms, such as a methyl group, an ethyl group, a propyl group, a butyl group, a pentyl group, a hexyl group, a cyclohexyl group, and a heptyl group; aryl groups, especially aryl groups having 6 to 14 carbon atoms, such as a phenyl group, a tolyl group, a xylyl group, and a naphthyl group; aralkyl groups, especially aralkyl groups having 7 to 14 carbon atoms, such as a benzyl group and a phenethyl group; and halogenated alkyl groups, especially halogenated alkyl groups having 1 to 3 carbon atoms, such as a chloromethyl group, a 3-chloropropyl group, and a 3,3,3-trifluoropropyl group. Particularly, preferred are a methyl group and a phenyl group.

Specific examples of the component (A) include a dimethylsiloxane-methylvinylsiloxane copolymer with both molecular chain ends being blocked by a trimethylsiloxy group; a methylvinylpolysiloxane with both molecular chain ends being blocked by a trimethylsiloxy group; a dimethylsiloxane-methylvinylsiloxane-methylphenylsiloxane copolymer with both molecular chain ends being blocked by a trimethylsiloxy group; a dimethylpolysiloxane with both molecular chain ends being blocked by a dimethylvinylsiloxy group; a methylvinylpolysiloxane with both molecular chain ends being blocked by a dimethylvinylsiloxy group; a dimethylsiloxane-methylvinylsiloxane copolymer with both molecular chain ends being blocked by a dimethylvinylsiloxy group; a dimethylsiloxane-methylvinylsiloxane-methylphenylsiloxane copolymer with both molecular chain ends being blocked by a dimethylvinylsiloxy group; a dimethylpolysiloxane with both molecular chain ends being blocked by a trivinylsiloxy group; an organopolysiloxane copolymer composed of a siloxane unit represented by a formula: $R^1_3SiO_{0.5}$ ($R^1$ represents a substituted or unsubstituted monovalent hydrocarbon group other than an alkenyl group; the same hereinafter), a siloxane unit represented by a formula: $R^1_2R^2SiO_{0.5}$ ($R^2$ represents an alkenyl group; the same hereinafter), a unit represented by a formula: $R^1_2SiO$, and a siloxane unit represented by a formula: $SiO_2$; an organopolysiloxane copolymer composed of the siloxane unit represented by the formula: $R^1_3SiO_{0.5}$, the siloxane unit represented by the formula: $R^1_2R^2SiO_{0.5}$, and the siloxane unit represented by the formula: $SiO_2$; an organopolysiloxane copolymer composed of the siloxane unit represented by the formula: $R^1_2R^2SiO_{0.5}$, the siloxane unit represented by the formula: $R^1_2SiO$, and the siloxane unit represented by the formula: $SiO_2$; and an organopolysiloxane copolymer composed of a siloxane unit represented by a formula: $R^1R^2SiO$ and a siloxane unit represented by a formula: $R^1SiO_{1.5}$ or a formula: $R^2SiO_{1.5}$. Any one kind of these components (A) may be used alone, or two or more kinds of them may be used in combination.

As $R^1$ in the above formulae, there may be listed, for example, alkyl groups such as a methyl group, an ethyl group, a propyl group, a butyl group, a pentyl group, a hexyl group, and a heptyl group; aryl groups such as a phenyl group, a tolyl group, a xylyl group, and a naphthyl group; aralkyl groups such as a benzyl group and a phenethyl group; and halogenated alkyl groups such as a chloromethyl group, a 3-chloropropyl group, and a 3,3,3-trifluoropropyl group. Further, as $R^2$ in the above formulae, there may be listed, for example, a vinyl group, an allyl group, a butenyl group, a pentenyl group, a hexenyl group, and a heptenyl group.

Component (B)

As a component (B) which is an organohydrogenpolysiloxane, there are no particular restrictions on the molecular structure thereof, and it will suffice so long as there are at least two silicon atom-bonded hydrogen atoms (hydrosilyl groups or SiH groups) per molecule; for example, there may be used various conventionally known organohydrogenpolysiloxanes such as those having a linear, a cyclic, a branched, and a three-dimensional network (resin type) structure.

The organohydrogenpolysiloxane as the component (B) has two or more, preferably three or more (normally, for example, 3 to 500, preferably 3 to 200, more preferably 3 to 100) silicon atom-bonded hydrogen atoms (hydrosilyl groups or SiH groups) per molecule. When the organohydrogenpolysiloxane as the component (B) has a linear structure, these SiH groups may be present only at the molecular chain ends or only at moieties other than the molecular chain ends; or be present both at the molecular chain ends and moieties other than the molecular chain ends.

The number of the silicon atoms per molecule of the component (B) (polymerization degree) is, for example,

preferably 2 to 1,000, more preferably 3 to 300, even more preferably 4 to 150. Further, the kinetic viscosity of the component (B) at 25°C is preferably 10 to 100,000 $mm^2/s$, more preferably 20 to 50,000 $mm^2/s$. Here, in this specification, the kinetic viscosity of the organopolysiloxane as the component (B) is a value measured by an Ostwald viscometer at 25°C.

As the component (B), there may, for example, be used an organohydrogenpolysiloxane represented by the following average composition formula (1).

[Chemical formula 1]

$$R^3_aH_bSiO_{(4-a-b)/2} \qquad (1)$$

(In this formula, $R^3$ represents a substituted or unsubstituted silicon atom-bonded monovalent hydrocarbon group preferably having 1 to 14, more preferably 1 to 10 carbon atoms, except an aliphatic unsaturated group; a and b are positive numbers preferably satisfying $0.7 \leq a \leq 2.1$, $0.001 \leq b \leq 1.0$, and $0.8 \leq a+b \leq 3.0$, more preferably satisfying $0.9 \leq a \leq 2.0$, $0.01 \leq b \leq 1.0$, and $1.0 \leq a+b \leq 2.5$.)

Examples of $R^3$ include alkyl groups such as a methyl group, an ethyl group, a propyl group, an isopropyl group, a butyl group, an isobutyl group, a tert-butyl group, a pentyl group, a neopentyl group, a hexyl group, a cyclohexyl group, an octyl group, a nonyl group, and a decyl group; aryl groups such as a phenyl group, a tolyl group, a xylyl group, and a naphthyl group; aralkyl groups such as a benzyl group, a phenylethyl group, and a phenylpropyl group; and groups obtained by substituting part of or all the hydrogen atoms in any of these hydrocarbon groups with halogen atoms such as fluorine, bromine, and chlorine atoms, where examples of such substituted groups may include a chloromethyl group, a 3-chloropropyl group, a bromoethyl group, and a 3,3,3-trifluoropropyl group. Preferred are an alkyl group and an aryl group; more preferred are a methyl group and a phenyl group.

The component (B) can be obtained by a known production method. As a general production method, there may, for example, be employed a method of equilibrating 1,3,5,7-tetramethyl-1,3,5,7-tetrahydrocyclotetrasiloxane (which may be a mixture of such cyclotetrasiloxane and octamethylcyclotetrasiloxane in certain cases) and a siloxane compound serving as an end group source, such as hexamethyldisiloxane and 1,3-dihydro-1,1,3,3-tetramethyldisiloxane, at a temperature of, for example, -10°C to +40°C under the presence of a catalyst such as sulfuric acid, trifluoromethanesulfonic acid, and methanesulfonic acid; or equilibrating octamethylcyclotetrasiloxane and 1,3-dihydro-1,1,3,3-tetramethyldisiloxane at a temperature of, for example, -10°C to +40°C under the presence of a catalyst such as sulfuric acid, trifluoromethanesulfonic acid, and methanesulfonic acid.

Specific examples of the component (B) include 1,1,3,3-tetramethyldisiloxane; 1,3,5,7-tetramethylcyclotetrasiloxane; tris(dimethylhydrogensiloxy)methylsilane; tris(dimethylhydrogensiloxy)phenylsilane; a methylhydrogenpolysiloxane with both molecular chain ends being blocked by a trimethylsiloxy group; a dimethylsiloxane-methylhydrogensiloxane copolymer with both molecular chain ends being blocked by a trimethylsiloxy group; a dimethylsiloxane-methylhydrogensiloxane-methylphenylsiloxane copolymer with both molecular chain ends being blocked by a trimethylsiloxy group; a dimethylpolysiloxane with both molecular chain ends being blocked by a dimethylhydrogensiloxy group; a dimethylpolysiloxane-methylhydrogensiloxane copolymer with both molecular chain ends being blocked by a dimethylhydrogensiloxy group; a dimethylsiloxane-methylphenylsiloxane copolymer with both molecular chain ends being blocked by a dimethylhydrogensiloxy group; a methylphenylpolysiloxane with both molecular chain ends being blocked by a dimethylhydrogensiloxy group; an organopolysiloxane copolymer composed of a siloxane unit represented by a formula: $R^1_3SiO_{0.5}$ ($R^1$ is defined and exemplified as above in the description of the component (A); the same hereinafter), a siloxane unit represented by a formula: $R^1_2HSiO_{0.5}$, and a siloxane unit represented by a formula: $SiO_2$; an organopolysiloxane copolymer composed of the siloxane unit represented by the formula: $R^1_2HSiO_{0.5}$ and the siloxane unit represented by the formula: $SiO_2$; and an organopolysiloxane copolymer composed of a siloxane unit represented by a formula: $R^1HSiO$ and a siloxane unit represented by a formula: $R^1SiO_{1.5}$ or a formula: $HSiO_{1.5}$. Any one kind of these components (B) may be used alone, or two or more kinds of them may be used in combination.

The component (B) is added in an amount at which the number of the silicon atom-bonded hydrogen atoms (SiH groups) in the component (B) is 0.8 to 6, preferably 1.5 to 3.0, per 1 alkenyl group in the entire composition. Here, a ratio of the silicon atom-bonded alkenyl groups in the component (A) to the alkenyl groups present in the entire composition is preferably 50 to 100 mol%, more preferably 80 to 100 mol%. If the component (A) is the only alkenyl group-containing component in the entire composition, the component (B) is added in an amount at which the number of the SiH groups in the component (B) will be 0.5 to 10, preferably 1.0 to 8.0, per 1 silicon atom-bonded alkenyl group in the component (A). An excessively small amount of the component (B) added may result in a poor adhesiveness to a base material; an excessively large amount of the component (B) added may lead to an impaired heat dissipation property.

Component (C)

A component (C) which is a catalyst for hydrosilylation reaction may be any catalyst so long as it is capable of promoting an addition reaction between the alkenyl groups in the component (A) and the SiH groups in the component (B). As the component (C), there may be used, for example, a platinum-based catalyst such as chloroplatinic acid, an alcohol-modified chloroplatinic acid, and a coordination compound of chloroplatinic acid and olefins, vinylsiloxane or an acetylene compound; a palladium-based catalyst such as tetrakis(triphenylphosphine)palladium; and a rhodium-based catalyst such as chlorotris(triphenylphosphine)rhodium. Particularly preferred is a platinum-based catalyst such as a platinum-divinyltetramethyldisiloxane complex.
There are no particular restrictions on the amount of the component (C) added so long as it is an effective amount of a catalyst for hydrosilylation reaction. The component (C) is preferably added in an amount of 0.1 to 2,000 ppm, more preferably 1 to 1,500 ppm, by mass in terms of catalytic metal element, per a total amount of the components (A) and (B). When the amount of the component (C) added is within these ranges, the addition reaction will be promoted sufficiently, the composition will be cured sufficiently, and it is also economically advantageous. Further, there are no particular restrictions on the type of the metal catalyst so long as it is a metal having an effective activity as a catalyst for hydrosilylation reaction; platinum or the like that has an activity of decomposing hydrogen gas into atoms is useful.

Component (D)

A component (D) is a silver powder having a tap density of not lower than 3.0 g/cm$^3$, a specific surface area of not larger than 2.0 m$^2$/g, and an aspect ratio of 2.0 to 50.0.
When the tap density of the silver powder as the component (D) is lower than 3.0 g/cm$^3$, a filling rate of the component (D) in the composition cannot be raised such that the viscosity of the composition will increase, and that the handling property of the composition will be impaired accordingly. Therefore, the tap density of the silver powder as the component (D) is preferably in a range of 3.0 to 10.0 g/cm$^3$, more preferably 4.5 to 10.0 g/cm$^3$, even more preferably 6.0 to 10.0 g/cm$^3$.
When the specific surface area of the silver powder as the component (D) is larger than 2.0 m$^2$/g, a filling rate of the component (D) in the composition cannot be raised such that the viscosity of the composition will increase, and that the handling property of the composition will be impaired accordingly. Therefore, the specific surface area of the silver powder as the component (D) is preferably in a range of 0.08 to 2.0 m$^2$/g, more preferably 0.08 to 1.0 m$^2$/g, even more preferably 0.08 to 0.5 m$^2$/g.
Here, the tap density mentioned in this specification is a value obtained as follows. That is, 100 g of a silver powder is weighed out at first, and then gently dropped into a 100 ml graduated cylinder with the aid of a funnel. The graduated cylinder is then placed on a tap density measuring device to drop the silver powder 600 times at a dropping distance of 20 mm and a rate of 60 times/min. Later, the volume of the compacted silver powder is measured.
Further, the specific surface area was calculated as follows. That is, about 2 g of the silver powder was taken as a sample, and then degassed at 60±5°C for 10 min, followed by using an automatic specific surface area measuring device (DET method) to measure a total surface area thereof. Later, the amount of the sample was measured, and the specific surface area was then calculated based on the following formula (2).
[Formula 1]

$$\text{Specific surface area (m}^2\text{/g)} = \text{Total surface area (m}^2\text{) / Sample amount (g)} \qquad (2)$$

The aspect ratio of the silver powder as the component (D) is in a range of 2.0 to 50.0, preferably 3.0 to 30.0, more preferably 3.0 to 20.0. The aspect ratio refers to a ratio between a major axis and a minor axis of a particle (major axis/minor axis). A method for measuring the aspect ratio is such that, for example, an electron micrograph of particles is taken at first, followed by measuring the major and minor axes of the particles based on such electron micrograph, and then calculating the aspect ratio therefrom. The size of the particles can be measured based on an electron micrograph taken from above, and a larger diameter in such electron micrograph taken from above is measured as a major axis. With respect to such major axis, a minor axis thus corresponds to the thickness of a particle. The thickness of a particle cannot be measured based on an electron micrograph taken from above. The thickness of a particle may be measured as follows. That is, when taking an electron micrograph, a sample stage on which the particles have been mounted is to be installed in a tilted manner, followed by taking the electron micrograph from above, and then performing correction based on the tilt angle of the sample stage so as to calculate the particle thickness. Specifically, after taking a few electron micrographs at a magnification ratio of several thousand times, the major and minor axes of any 100 silver particles were measured, followed by calculating the ratios between these major and minor axes (major axis/minor axis), and then obtaining an average value thereof as the aspect ratio.

Although there are no particular restrictions on the particle size of the silver powder as the component (D), it is preferred that the average particle size thereof be 0.2 to 50 $\mu$m, particularly preferably 1.0 to 30 $\mu$m. The "average particle size" mentioned in this specification refers to a volume average diameter [MV] on volumetric basis that is measured by a laser diffraction-type particle size analyzer as follows. That is, before measurement, the silver powder is at first taken by one to two scoops with a microspatula and put into a 100 ml beaker, followed by putting about 60 ml of isopropyl alcohol thereinto, and then using an ultrasonic homogenizer to disperse the silver powder for a minute. Here, a measurement time was 30 seconds.

Although there are no particular restrictions on a method for producing the silver powder used in the present invention, it is preferred that the silver powder be that produced by a reduction method.

The silver powder produced via the above method may be used as it is; or crushed before use, provided that the aforementioned numerical value ranges are satisfied. If crushing the silver powder, there are no particular restrictions on a device for crushing the same. There can be used, for example, known devices such as a stamp mill, a ball mill, a vibrating mill, a hammer mill, a rolling roller, and a mortar. Among them, preferred are a stamp mill, a ball mill, a vibrating mill, and a hammer mill.

The component (D) is added in an amount of 500 to 3,000 parts by mass per 100 parts by mass of the component (A). When the component (D) is in an amount of smaller than 500 parts by mass per 100 parts by mass of the component (A), a cured product of the composition obtained will exhibit an impaired thermal conductivity; when the component (D) is in an amount of larger than 3,000 parts by mass per 100 parts by mass of the component (A), the composition will exhibit an impaired fluidity and a poor handling property thereby. It is preferred that the component (D) be added in an amount of 600 to 2,000 parts by mass, more preferably 700 to 1,500 parts by mass, per 100 parts by mass of the component (A).

Component (E)

A component (E) is a spherical silver powder having an average particle size of 0.5 to 100 $\mu$m, a tap density of not lower than 4.0 g/cm$^3$, a specific surface area of not larger than 1.5 m$^2$/g, and an aspect ratio of smaller than 2.0.

When the average particle size of the spherical silver powder as the component (E) is smaller than 0.5 $\mu$m, the cured product of the composition obtained will exhibit an impaired thermal conductivity. Further, an average particle size of larger than 100 $\mu$m will make heat path formation difficult in the cured product of the composition obtained, and thus lead to an impaired thermal conductivity; therefore, the average particle size of the spherical silver powder as the component (E) is preferably 1.0 to 50 $\mu$m, more preferably 2.0 to 10 $\mu$m.

When the tap density of the spherical silver powder as the component (E) is lower than 4.0 g/cm$^3$, a filling rate of the component (E) in the composition cannot be raised such that the viscosity of the composition will increase, and that the handling property of the composition will be impaired accordingly. Therefore, the tap density of the spherical silver powder as the component (E) is preferably in a range of 4.0 to 10.0 g/cm$^3$, more preferably 4.5 to 10.0 g/cm$^3$, even more preferably 6.0 to 10.0 g/cm$^3$.

When the specific surface area of the spherical silver powder as the component (E) is larger than 1.5 m$^2$/g, a filling rate of the component (E) in the composition cannot be raised such that the viscosity of the composition will increase, and that the handling property of the composition will be impaired accordingly. Therefore, the specific surface area of the spherical silver powder as the component (E) is preferably in a range of 0.08 to 1.5 m$^2$/g, more preferably 0.08 to 1.0 m$^2$/g, even more preferably 0.08 to 0.5 m$^2$/g.

The aspect ratio of the spherical silver powder as the component (E) is smaller than 2.0, preferably not larger than 1.5, even more preferably not larger than 1.2. Here, the aspect ratio refers to a ratio between a major axis and a minor axis of a particle (major axis/minor axis). A measurement method thereof is identical to the method described above.

Although there are no particular restrictions on a method for producing the spherical silver powder as the component (E), it is preferred that the spherical silver powder be produced by an atomizing method.

The component (E) is added in an amount of 500 to 3,000 parts by mass per 100 parts by mass of the component (A). When the component (E) is in an amount of smaller than 500 parts by mass per 100 parts by mass of the component (A), the cured product of the composition obtained will exhibit an impaired thermal conductivity; when the component (E) is in an amount of larger than 3,000 parts by mass per 100 parts by mass of the component (A), the composition will exhibit an impaired fluidity and a poor handling property thereby. It is preferred that the component (E) be added in an amount of 600 to 2,000 parts by mass, more preferably 700 to 1,500 parts by mass, per 100 parts by mass of the component (A).

A ratio $\alpha/\beta$ of a mass $\alpha$ of the component (D) to a mass $\beta$ of the component (E) is preferably 0.1 to 6, more preferably 0.2 to 5.5, even more preferably 0.5 to 5, most preferably 0.8 to 4. When such ratio $\alpha/\beta$ is within these ranges, the cured product of the composition obtained will exhibit a more excellent thermal conductivity.

Other components

In addition to the components (A) to (E), the thermal conductive silicone composition of the present invention may further contain the following components as optional components.

Curing reaction control agent

The composition of the present invention may employ a curing reaction control agent having a curing inhibition effect to the addition reaction catalyst. Examples of such compound include a phosphorus-containing compound (e.g., triphenylphosphine), a nitrogen-containing compound (e.g., tributylamine, tetramethylethylenediamine; and benzotriazole), a sulfur-containing compound, an acetylene-based compound (e.g., 1-ethynyl-1-cyclohexanol), triallylisocyanuric acid, a hydroperoxy compound, and a maleic acid derivative. The degree of a curing delay effect by the curing reaction control agent varies significantly depending on the chemical structure of the curing reaction control agent. Thus, the additive amount of the curing reaction control agent may be adjusted to a most appropriate amount per each type of curing reaction control agent used, and those skilled in the art can easily make such adjustment via a known method. By adding a curing reaction control agent to the composition of the present invention, the composition of the present invention will be endowed with a long-term storage stability at room temperature; however, if such curing reaction control agent is added in an excessively large amount, curing of the composition may be inhibited.

Inorganic compound powder other than components (D) and (E); and/or organic compound material

As an inorganic compound powder other than the components (D) and (E); and/or an organic compound material, there may be listed, for example, a metal powder such as an aluminum powder, a gold powder, a copper powder, a nickel powder, an indium powder, a gallium powder, a palladium powder, and a metallic silicon powder; a diamond powder; a carbon material such as carbon fibers, graphene, graphite, carbon nanotubes, and carbon black; a metal oxide powder such as a zinc oxide powder, a titanium oxide powder, a magnesium oxide powder, an alumina powder, an iron oxide powder, and a silicon dioxide powder (e.g., fumed silica, crystalline silica, and precipitated silica); a metal hydroxide powder such as an aluminum hydroxide powder; a nitride powder such as a boron nitride powder and an aluminum nitride powder; a carbonate such as magnesium carbonate, calcium carbonate, and zinc carbonate; a hollow filler; silsesquioxane; layered mica; diatomaceous earth; glass fibers; a silicone rubber powder; and a silicone resin powder.

Among them, preferred are those with a high thermal conductivity. As an inorganic compound powder and/or organic compound material having a high thermal conductivity, there may be listed, for example, an aluminum powder, a zinc oxide powder, a titanium oxide powder, a magnesium oxide powder, an alumina powder, an aluminum hydroxide powder, a boron nitride powder, an aluminum nitride powder, a diamond powder, a gold powder, a copper powder, a carbon powder, a nickel powder, an indium powder, a gallium powder, a metallic silicon powder, a silicon dioxide powder, carbon fibers, graphene, graphite, and carbon nanotubes. Any one kind of these powders and materials may be used alone, or two or more kinds of them may be used in combination.

If necessary, the surfaces of these inorganic compound powders and organic compound materials may be hydrophobized with, for example, an organosilane, organosilazane, organopolysiloxane, or organic fluorine compound. As for the average particle size of such inorganic compound powder(s) and organic compound material(s), neither a size smaller than 0.5 $\mu$m nor a size larger than 100 $\mu$m will contribute to a rise in a filling rate of the inorganic compound powder(s) and organic compound material(s) in the composition. Thus, the average particle size of such inorganic compound powder(s) and organic compound material(s) is preferably 0.5 to 100 $\mu$m, particularly preferably 1 to 50 $\mu$m. Further, as for the fiber length of carbon fibers, neither a length shorter than 10 $\mu$m nor a length longer than 500 $\mu$m will contribute to a rise in a filling rate of the carbon fibers in the composition. Thus, the carbon fibers used preferably have a fiber length of 10 to 500 $\mu$m, particularly preferably 30 to 300 $\mu$m.

When a total amount of the inorganic compound powder(s) and organic compound material(s) added is larger than 3,000 parts by mass per 100 parts by mass of the component (A), the composition will exhibit an impaired fluidity and a poor handling property thereby. Thus, it is preferred that such total amount be 0.1 to 3,000 parts by mass, particularly preferably 1 to 2,000 parts by mass.

Further, to the extent that the purposes of the present invention are not undermined, the composition of the present invention may further contain other optional components such as an organopolysiloxane having one silicon atom-bonded hydrogen atom or silicon atom-bonded alkenyl group per molecule, an organopolysiloxane containing neither silicon atom-bonded hydrogen atoms nor silicon atom-bonded alkenyl groups, an organic solvent, a heat resistance imparting agent, a flame retardance imparting agent, a plasticizer, a thixotropy imparting agent, a dye, and a fungicide.

Production method

The thermal conductive silicone composition of the present invention may be produced by a conventionally known method for producing a silicone composition, and there are no particular restrictions on such method. For example, the thermal conductive silicone composition of the present invention can be produced by mixing the above components (A) to (E) together with other components that are employed as appropriate for 10 min to 4 hours, using a mixer such as Trimix, Twin Mix, and Planetary Mixer (registered trademarks of mixers manufactured by INOUE MFG., INC.); a mixer such as Ultramixer (registered trademark of mixer manufactured by MIZUHO INDUSTRIAL CO., LTD); or a mixer such as Hivis Disper Mix (registered trademark of mixer manufactured by PRIMIX Corporation). Further, mixing may be performed while performing heating at 30 to 200°C as necessary.

The absolute viscosity of the thermal conductive silicone composition of the present invention measured at 25°C is preferably 10 to 1,000 Pa s, more preferably 50 to 700 Pa·s, even more preferably 80 to 600 Pa·s. When the absolute viscosity is within the above ranges, a favorable grease can be provided, and there can be achieved an excellent workability as well. The above absolute viscosity can be achieved by regulating the amount of each component to the abovementioned amount(s). The absolute viscosity can, for example, be measured by PC-1TL (10 rpm) manufactured by Malcom Co., Ltd.

The thermal conductive silicone composition obtained in the above manner cures when heated to a temperature of 80°C or higher while being subjected to a pressure of 0.01 MPa or higher. There are no restrictions on the property of the cured product thus obtained; the cured product may, for example, be a gel-like matter, a low-hardness rubber-like matter, or a high-hardness rubber-like matter.

Semiconductor device

A semiconductor device of the present invention is such that the cured product of the thermal conductive silicone composition of the invention is interposed between the surface of a heat-generating electronic part and a heat dissipator. It is preferred that the cured product of the thermal conductive silicone composition of the invention that is interposed have a thickness of 10 to 200 μm.

Although a typical structure of the semiconductor device of the invention is shown in FIG. 1, the semiconductor device is not limited to that shown in FIG. 1. FIG. 1 is a vertical cross-sectional schematic diagram showing one example of the semiconductor device of the present invention; for example, the semiconductor device of the present invention is one in which a thermal conductive silicone composition layer 3 is interposed between a heat-generating electronic part (CPU) 2 mounted on a substrate 1 and a heat dissipator (lid) 4, where the thermal conductive silicone composition layer 3 is the cured product of the thermal conductive silicone composition of the present invention.

As a method for producing the semiconductor device of the present invention, preferred is a method where the thermal conductive silicone composition of the invention that is interposed between the heat-generating electronic part and the heat dissipator is to be heated to a temperature of 80°C or higher while being subjected to a pressure of 0.01 MPa or higher. At that time, the pressure applied is preferably 0.01 MPa or higher, more preferably 0.05 to 100 MPa, and even more preferably 0.1 to 100 MPa. The heating temperature needs to be 80°C or higher; the heating temperature is preferably 100 to 300°C, more preferably 120 to 300°C, and even more preferably 140 to 300°C.

WORKING EXAMPLES

The present invention is described in greater detail hereunder with reference to working and comparative examples to further clarify the effects of the invention. However, the present invention shall not be limited to these examples. Here, the kinetic viscosities of the components (A) and (B) are values measured by an Ostwald viscometer at 25°C.

The components used in the working and comparative examples are shown below.

Component (A)

A-1: Dimethylpolysiloxane with both ends blocked by a dimethylvinylsilyl group, and having a kinetic viscosity of 600 $mm^2/s$ at 25°C

Component (B)

B-1: Organohydrogenpolysiloxane represented by the following formula (kinetic viscosity at 25°C: 30 $mm^2/s$)

[Chemical formula 2]

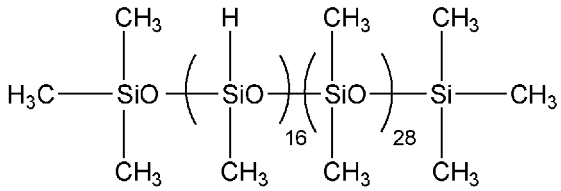

Component (C)

C-1 (Platinum catalyst): A-1 solution of platinum-divinyltetramethyldisiloxane complex that contains 1 wt% of platinum in terms of platinum atoms

Component (D)

D-1: Silver powder having a tap density of 5.5 g/cm$^3$, a specific surface area of 0.8 m$^2$/g, an aspect ratio of 8.0, and an average particle size of 2 μm

D-2: Silver powder having a tap density of 6.2 g/cm$^3$, a specific surface area of 0.5 m$^2$/g, an aspect ratio of 13.0, and an average particle size of 4 μm

D-3: Silver powder having a tap density of 9.0 g/cm$^3$, a specific surface area of 0.2 m$^2$/g, an aspect ratio of 30.0, and an average particle size of 10 μm

D-4: Silver powder having a tap density of 3.0 g/cm$^3$, a specific surface area of 2.0 m$^2$/g, an aspect ratio of 47.0, and an average particle size of 14 μm

D-5: (Comparative example) Silver powder having a tap density of 2.3 g/cm$^3$, a specific surface area of 1.8 m$^2$/g, an aspect ratio of 3.0, and an average particle size of 1 μm D-6: (Comparative example) Silver powder having a tap density of 3.3 g/cm$^3$, a specific surface area of 3.0 m$^2$/g, an aspect ratio of 4.0, and an average particle size of 0.1 μm

Component (E)

E-1: Spherical silver powder having an average particle size of 3 μm, a tap density of 6.5 g/cm$^3$, a specific surface area of 0.3 m$^2$/g, and an aspect ratio of 1.2

E-2: Spherical silver powder having an average particle size of 0.8 μm, a tap density of 4.3 g/cm$^3$, a specific surface area of 1.2 m$^2$/g, and an aspect ratio of 1.5

E-3: Spherical silver powder having an average particle size of 70 μm, a tap density of 6.0 g/cm$^3$, a specific surface area of 0.2 m$^2$/g, and an aspect ratio of 1.1

E-4: (Comparative example) Spherical silver powder having an average particle size of 0.3 μm, a tap density of 3.8 g/cm$^3$, a specific surface area of 2.2 m$^2$/g, and an aspect ratio of 1.6

E-5: (Comparative example) Spherical silver powder having an average particle size of 105 μm, a tap density of 5.0 g/cm$^3$, a specific surface area of 0.5 m$^2$/g, and an aspect ratio of 1.8

Component (F): Curing reaction control agent

F-1: 1-ethynyl-1-cyclohexanol

[Working examples 1 to 9; and comparative examples 1 to 8]

The components were mixed as follows at the compounding ratios shown in Tables 1 and 2 (numerical value of each component represents part(s) by mass), and compositions of working examples 1 to 9 and comparative examples 1 to 8 were obtained.

Specifically, the components (A), (D), and (E) were put into a 5L planetary mixer (by INOUE MFG., INC.), and were mixed at 25°C for 1.5 hours. Next, the components (C) and (F) were added thereto, and mixing was performed at 25°C for another 15 min. In the end, the component (B) was further added thereto, and mixing was performed until uniform.

[Viscosity]

The absolute viscosity of each composition was measured by a Malcom viscometer (type PC-1TL) at 25°C.

[Thermal resistance]

Each composition was then sandwiched between two pieces of φ 12.7 mm aluminum plate, and was further placed in an oven of 150°C for 90 min while being subjected to a pressure of 0.35 MPa. The composition was thus thermally cured to obtain a test piece. In view of presence or non-presence of a spacer when sandwiching the composition and differences in thickness (i.e., no spacer, 75 μm, 100 μm), there were prepared three kinds of test pieces respectively having a minimum thickness when compressed (BLT), a thickness of 75 μm, and a thickness of 100 μm. Each one of these test pieces was then subjected to thermal resistance measurement at 25°C, using Nanoflash (LFA447 by NETZSCH Japan K.K.). Here, BLT measurement was carried out by a digimatic outside micrometer (MDC-25MX by Mitutoyo Corporation), and BLT was calculated by the following formula (3).
[Formula 2]

BLT (μm) = Thickness of test piece (μm) - Thickness of two pieces of aluminum plate used (μm) (3)

[Table 1]

| | | Working example | | | | | | | | |
|---|---|---|---|---|---|---|---|---|---|---|
| | | 1 | 2 | 3 | 4 | 5 | 6 | 7 | 8 | 9 |
| A-1 | | 100 | 100 | 100 | 100 | 100 | 100 | 100 | 100 | 100 |
| B-1 | | 6.73 | 6.73 | 6.73 | 6.73 | 6.73 | 6.73 | 6.73 | 6.73 | 6.73 |
| C-1 | | 5.48 | 5.48 | 5.48 | 5.48 | 5.48 | 5.48 | 5.48 | 5.48 | 5.48 |
| D-1 | | 1250 | 2800 | 2800 | 550 | 1250 | 1250 | | | |
| D-2 | | | | | | | | 1250 | | |
| D-3 | | | | | | | | | 1250 | |
| D-4 | | | | | | | | | | 1250 |
| E-1 | | 1250 | 550 | 2800 | 2800 | | | 1250 | 1250 | 1250 |
| E-2 | | | | | | 1250 | | | | |
| E-3 | | | | | | | 1250 | | | |
| F-1 | | 0.20 | 0.20 | 0.20 | 0.20 | 0.20 | 0.20 | 0.20 | 0.20 | |
| α/β | | 1.0 | 5.1 | 1.0 | 0.2 | 1.0 | 1.0 | 1.0 | 1.0 | 1.0 |
| Viscosity (Pa·s) | | 500 | 580 | 900 | 650 | 600 | 650 | 450 | 400 | 700 |
| BLT(μm) | | 20 | 15 | 35 | 30 | 12 | 72 | 20 | 20 | 20 |
| Thermal resistance ($mm^2$ · K/W) | BLT | 2.0 | 1.7 | 2.8 | 3.6 | 1.5 | 7.5 | 1.8 | 1.6 | 3.0 |
| | 75μm | 6.5 | 6.0 | 5.9 | 7.6 | 7.8 | 7.7 | 6.3 | 6.0 | 8.0 |
| | 100μm | 8.6 | 8.0 | 7.7 | 10.4 | 10.0 | 10.5 | 8.3 | 8.1 | 10.8 |

[Table 2]

| | Comparative example | | | | | | | |
|---|---|---|---|---|---|---|---|---|
| | 1 | 2 | 3 | 4 | 5 | 6 | 7 | 8 |
| A-1 | 100 | 100 | 100 | 100 | 100 | 100 | 100 | 100 |
| B-1 | 6.73 | 6.73 | 6.73 | 6.73 | 6.73 | 6.73 | 6.73 | 6.73 |

(continued)

| | | Comparative example | | | | | | | |
|---|---|---|---|---|---|---|---|---|---|
| | | 1 | 2 | 3 | 4 | 5 | 6 | 7 | 8 |
| C-1 | | 5.48 | 5.48 | 5.48 | 5.48 | 5.48 | 5.48 | 5.48 | 5.48 |
| D-1 | | 450 | 3300 | 1250 | 1250 | | | 2800 | 450 |
| D-5 | | | | | | 550 | | | |
| D-6 | | | | | | | 550 | | |
| E-1 | | 450 | 3300 | | | 1250 | 1250 | 450 | 2800 |
| E-4 | | | | 1250 | | | | | |
| E-5 | | | | | 1250 | | | | |
| F-1 | | 0.2 | 0.2 | 0.2 | 0.2 | 0.2 | 0.2 | 0.2 | 0.2 |
| $\alpha/\beta$ | | 1.0 | 1.0 | 1.0 | 1.0 | 1.0 | 1.0 | 6.2 | 0.2 |
| Viscosity (Pa·s) | | 500 | Failed to turn into a grease-like matter | 600 | 700 | 1200 | 1300 | 500 | 600 |
| BLT($\mu$m) | | 20 | | 8 | 110 | 20 | 20 | 15 | 30 |
| Thermal resistance (mm$^2$·K/W) | BLT | 4.0 | | 0.8 | 22.0 | 15.0 | 15.2 | 2.0 | 4.0 |
| | 75$\mu$m | 15.0 | | 16.0 | - | 20.0 | 18.3 | 20.3 | 19.8 |
| | 100$\mu$m | 20.0 | | 25.0 | - | 30.0 | 28.8 | 28.2 | 29.7 |

As shown in Table 1, the cured product of the thermal conductive silicone composition of the present invention exhibited a sufficiently low thermal resistance even in the cases of thicknesses larger than the minimum thickness when compressed (BLT).

In contrast, as shown in Table 2, in the comparative example 1 where the components (D) and (E) were added in small amounts, a high thermal resistance was observed, whereby a desired thermal performance was unable to be achieved. In the comparative example 2 where the components (D) and (E) were added in large amounts, the composition failed to turn into a grease-like matter, and thus exhibited a poor handling property. In the comparative example 3 where the component (E) had a small average particle size, high thermal resistances were observed with larger thicknesses; in the comparative example 4 where the component (E) had a large average particle size, a high thermal resistance was observed, and thermal resistance was unable to be measured with larger thicknesses. In the comparative examples 5 and 6 where the silver powders used had tap densities or specific surface areas that were out of the ranges of the component (D) used in the present invention, the compositions obtained exhibited high viscosities, and high thermal resistances were observed as well. Further, in the comparative examples 7 and 8 where one of the components (D) and (E) was added in a small amount, higher thermal resistances were observed with larger thicknesses.

DESCRIPTION OF THE SYMBOLS

1. Substrate
2. Heat-generating electronic part (CPU)
3. Thermal conductive silicone composition layer
4. Heat dissipator (lid)

**Claims**

**1.** A thermal conductive silicone composition comprising:

(A) 100 parts by mass of an organopolysiloxane that has a kinetic viscosity of 10 to 100,000 mm$^2$/s at 25°C, and contains at least two silicon atom-bonded alkenyl groups per molecule;
(B) an organohydrogenpolysiloxane that contains at least two silicon atom-bonded hydrogen atoms (SiH groups)

per molecule, and is in an amount at which the number of the silicon atom-bonded hydrogen atoms in the component (B) is 0.8 to 6 per 1 alkenyl group in the entire composition;
(C) an effective amount of a catalyst for hydrosilylation reaction;
(D) 500 to 3,000 parts by mass of a silver powder having a tap density of not lower than 3.0 g/$cm^3$, a specific surface area of not larger than 2.0 $m^2$/g, and an aspect ratio of 2.0 to 50; and
(E) 500 to 3,000 parts by mass of a spherical silver powder having an average particle size of 0.5 to 100 μm, a tap density of not lower than 4.0 g/$cm^3$, a specific surface area of not larger than 1.5 $m^2$/g, and an aspect ratio of smaller than 2.0.

**2.** The thermal conductive silicone composition according to claim 1, wherein a ratio $\alpha/\beta$ of a mass $\alpha$ of the component (D) to a mass $\beta$ of the component (E) is 0.1 to 6.

**3.** A cured product of the thermal conductive silicone composition according to claim 1 or 2.

**4.** A semiconductor device comprising a heat-generating electronic part and a heat dissipator wherein the cured product of the thermal conductive silicone composition according to claim 3 is interposed between the heat-generating electronic part and the heat dissipator.

**5.** A method for producing a semiconductor device, comprising a step in which the thermal conductive silicone composition according to claim 1 or 2 that is interposed between a heat-generating electronic part and a heat dissipator is heated to a temperature of 80°C or higher while being subjected to a pressure of 0.01 MPa or higher.

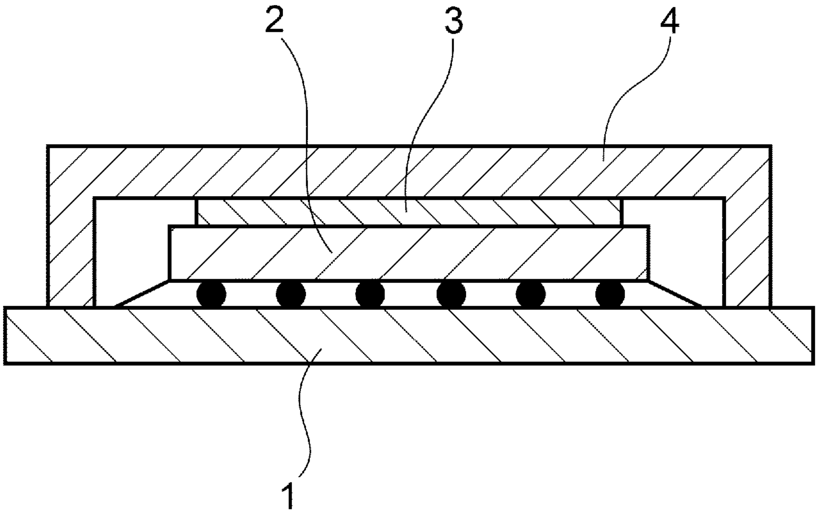


FIG.1

## INTERNATIONAL SEARCH REPORT

International application No. **PCT/JP2022/025063**

**A. CLASSIFICATION OF SUBJECT MATTER**

***C08L 83/04***(2006.01)i; ***C08K 3/08***(2006.01)i
FI: C08L83/04; C08K3/08

According to International Patent Classification (IPC) or to both national classification and IPC

**B. FIELDS SEARCHED**

Minimum documentation searched (classification system followed by classification symbols)

C08L1/00-101/16, C08K3/00-13/08

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2017/159252 A1 (SHIN-ETSU CHEMICAL CO., LTD.) 21 September 2017 (2017-09-21)<br>claims, example 8 | 1-5 |
| A | WO 2020/241054 A1 (SHIN-ETSU CHEMICAL CO., LTD.) 03 December 2020 (2020-12-03)<br>claims | 1-5 |
| A | JP 2018-058953 A (SHIN-ETSU CHEMICAL CO., LTD.) 12 April 2018 (2018-04-12)<br>claims | 1-5 |
| A | WO 2018/079362 A1 (SHIN-ETSU CHEMICAL CO., LTD.) 03 May 2018 (2018-05-03)<br>claims | 1-5 |
| A | WO 2020/137332 A1 (SHIN-ETSU CHEMICAL CO., LTD.) 02 July 2020 (2020-07-02)<br>claims | 1-5 |
| A | WO 2020/129555 A1 (SHIN-ETSU CHEMICAL CO., LTD.) 25 June 2020 (2020-06-25)<br>claims | 1-5 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 August 2022** | **30 August 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/025063**

**C. DOCUMENTS CONSIDERED TO BE RELEVANT**

| Category* | Citation of document, with indication, where appropriate, of the relevant passages | Relevant to claim No. |
|---|---|---|
| A | JP 2017-066406 A (SHIN-ETSU CHEMICAL CO., LTD.) 06 April 2017 (2017-04-06) claims | 1-5 |
| A | JP 2021-098768 A (SHIN-ETSU CHEMICAL CO., LTD.) 01 July 2021 (2021-07-01) claims | 1-5 |
| A | JP 2016-509086 A (DOW CORNING CORP.) 24 March 2016 (2016-03-24) claims | 1-5 |

Form PCT/ISA/210 (second sheet) (January 2015)

**INTERNATIONAL SEARCH REPORT**
**Information on patent family members**

International application No.
**PCT/JP2022/025063**

| Patent document cited in search report | Publication date (day/month/year) | Patent family member(s) | Publication date (day/month/year) |
|---|---|---|---|
| WO 2017/159252 A1 | 21 September 2017 | US 2019/0002694 A1<br>claims, example 8<br>CN 108603033 A<br>KR 10-2018-0127325 A<br>TW 201800488 A | |
| WO 2020/241054 A1 | 03 December 2020 | EP 3979314 A1<br>claims<br>JP 2020-193250 A<br>CN 113853676 A<br>TW 202106810 A | |
| JP 2018-058953 A | 12 April 2018 | (Family: none) | |
| WO 2018/079362 A1 | 03 May 2018 | US 2021/0284803 A1<br>claims<br>JP 2018-70800 A<br>EP 3533836 A1<br>CN 110023409 A<br>KR 10-2019-0077345 A<br>TW 201821584 A | |
| WO 2020/137332 A1 | 02 July 2020 | JP 2020-100760 A<br>JP 2020-100761 A<br>TW 202033665 A | |
| WO 2020/129555 A1 | 25 June 2020 | US 2022/0044983 A1<br>claims<br>EP 3901998 A1<br>CN 113228262 A<br>KR 10-2021-0105942 A<br>TW 202033621 A | |
| JP 2017-066406 A | 06 April 2017 | US 2017/0096591 A1<br>claims<br>EP 3150672 A1<br>KR 10-2017-0040107 A<br>CN 106905704 A<br>TW 201730276 A | |
| JP 2021-098768 A | 01 July 2021 | (Family: none) | |
| JP 2016-509086 A | 24 March 2016 | US 2015/0315437 A1<br>claims<br>WO 2014/099639 A1<br>EP 2935429 A1<br>CN 104854176 A<br>KR 10-2015-0096674 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP HEI2153995 A
- JP HEI314873 A
- JP HEI10110179 A
- JP 00063872 A
- JP 2002030217 A
- JP 2000063873 A
- JP 2008222776 A
- JP 3130193 B
- JP 3677671 B
- JP 2000063872 A